# EUROPEAN PATENT SPECIFICATION

(11) **EP 4 001 559 B1**
(45) Date of publication and mention of the grant of the patent: **02.08.2023**
(21) Application number: 20382983.3
(22) Date of filing: 13.11.2020
(51) Int. Cl.: E05B 47/00

(54) **ELECTRICALLY ACTUATED DEVICE FOR ELECTRIC STRIKES**
ELEKTRISCH BETÄTIGTES GERÄT FÜR ELEKTRISCHE TÜRÖFFNER
ACTIONNEUR ÉLECTRIQUE POUR GÂCHE ÉLECTRIQUE

(43) Date of publication of application: 25.05.2022
(73) Proprietor: Openers & Closers, S.L., 08980 Sant Feliu de Llobregat (Barcelona) (ES)
(72) Inventor: ANDREU PALLEROLA, Roger, 08980 Sant Feliu de Llobregat (Barcelona) (ES); ANDREU PALLEROLA, Bernat, 08980 Sant Feliu de Llobregat (Barcelona) (ES)
(74) Representative: Carbonell Callicó, Josep

(56) References cited:
- DE-A1-102010 018 176
- DE-A1-102013 114 519
- ES-A1- 2 651 448

## Description

### Technical field.

The present invention relates to an electrically actuated device that can be applied in electric strikes of doors and enclosures having a moving leaf relative to a frame.

### Prior state of the art.

Most electric strikes currently on the market have power strips that are custom designed for a specific product. Even so, most of them have the same architecture and consist of a plastic base to which metal terminals are assembled and/or riveted.

A screw that is used so that the installer can connect the power cable is screwed on these terminals on the outer portion. On the inside, the solenoid wires are joined to the terminals of the power strip by manual tin soldering. An element is often added (also with soldering) to protect the mechanism against voltage surges.

Different types of power strips are currently known:
A basic power strip has two terminals that are simply positioned at the base of the power strip to then screw in the screws and solder the solenoid wire. On this power strip, if the screw is completely removed, the terminal can move, breaking the tin joint between the wire and the solenoid.

These power strips possibly include an element for protecting against voltage surges and the terminals are riveted so that they remain fixed to the plastic. This is an additional operation in the assembly process, but it ensures the soldering of the solenoid wire with the terminal. On this power strip, even if the screw is removed, the terminal remains joined to the base of the power strip.

Power strips that have internal protection for the screws, in addition to the possible element for protecting against voltage surges, are also known. These power strips have an inner cover that encapsulates said possible protection element and the tip of the screws, leaving only the tip of the terminal where the solenoid wire is soldered in view. In this way, the power strip is provided with extra protection against possible internal contact that may cause the electric strike to malfunction.

Another known type of power strips are those that have a possible element for protecting against voltage surges and a voltage selector, for example of 12/24V AC/DC. These power strips consist of a small circuit with a switch that, together with a dual-coil solenoid, makes it possible to change the voltage at which the electric strike operates. The mentioned circuit consists of 4 tracks for soldering the two coils. Then, depending on the position of the switch pins, the coils work in parallel, or in series, to power the electric strike, for example at 12V AC/DC or 24V AC/DC, respectively.

Connection power strips that incorporate a microswitch to control the status of the door are also known. This power strip, in addition to powering the electric strike, includes a microswitch that provides information on the status of the door by means of a cam that actuates it. These power strips are based on a PCBA circuit that possibly incorporates an element for protecting against voltage surges, a microswitch and a power strip-block; and it has a plastic base that is assembled on the PCBA circuit and a cover that is assembled to protect the PCBA circuit; the solenoid wire being soldered to the PCBA circuit next to the element.

The ends of the solenoid wire are always free for soldering to the coil terminals.

The wire is generally protected by a flexible tube from the coil reel, leaving only the end for soldering free. The tube protects the thread against friction but, even so, the assembly is prone to breakage of the wire when handling it.

In all cases mentioned, a manual or automated operation is carried out to solder the solenoid wires to the terminals. It should be noted that the wire generally used in this type of solenoid has diameters between 0.05 mm and 0.30 mm. These sections make the tip of the wire difficult to control and the solder weak, which can break when handling the assembly during product assembly.

Another drawback of this type of power strip is related to the riveting and threading operations of the terminals.

ES 2651448 A1 discloses an electrically actuated device for electric strikes, comprising a pivoting latch, a solenoid connected to an electrical power strip and which when powered moves a core of the solenoid that acts on the locking and unlocking mechanism of the pivoting latch, wherein the electrical power strip comprises a PCBA circuit with screw terminals for mounting power screws.

### Description of the invention

The electrically actuated device for electric strikes object of the invention has technical features aimed at mounting the solenoid power strip, regardless of the type of power provided by said power strip or the functions performed by the same.

Another objective of the invention is to improve and simplify the connection of the solenoid to the power strip, solving the problem currently posed by the soldering of the thin coil wires to the terminals of the power strip and the risk of accidental breakage of the solder or wires when mounting or handling the electric strike.

Another object of the invention is that the connection between the solenoid and the power strip additionally provides a mechanical joint therebetween, so that the mounting thereof can be automated and they form a solid and/or resistant assembly.

Another objective of the invention is to improve and simplify the connection of the power strip to the power supply, solving the problem currently posed by the riveting and threading operations of the terminals with the base of the power strip, so that the mounting thereof can be automated and they form a solid and/or resistant assembly.

According to the invention, in a basic embodiment the power strip of the electric strike solenoid comprises:
- a PCBA circuit comprising: screw terminals for mounting power screws; and possibly an element for protecting against voltage surges;
- a plastic base that can be coupled to the outside of an electric strike and has clips on the inner surface thereof for the pressure coupling and retention of the integrated circuit and through holes for the fitted housing of the screw terminals of the integrated circuit, such that in the coupling position with the base the PCBA circuit has completely restricted movement and,
- rigid pins or connectors that establish an electrical connection between the PCBA circuit and a solenoid coil and mechanically secure the solenoid and the power strip in a solid and/or resistant assembly.

In said basic embodiment, the fastening clips protrude perpendicularly from the base of the power strip for attaching to at least two opposite sides of the PCBA circuit.

The assembly is carried out by placing the PCBA circuit parallel to the base and perpendicular to the base, causing the clips of the base to elastically deform, allowing the PCBA circuit to enter the housing.

As mentioned, the connection strip may be suitable to provide different power supplies or include additional functions.

In one embodiment of the invention, the PCBA circuit of the power strip additionally includes the suitable components for allowing the solenoid to be powered in a range of 100% ED AC/DC, always having an optimal power flow to improve functionality. Due to the need to incorporate more components, in this embodiment the PCBA circuit is larger in size but the assembly has the same assembly architecture, with a clip at the plastic base and connector for the solenoid, like the basic embodiment described above.

In this invention, keeping the assembly model of the PCBA circuit with a clip at the base and connector for the solenoid, it has been envisaged that said PCBA circuit can be dimensioned and incorporate the necessary components to form: a timed electronic power strip, capable of providing the solenoid with power for a few seconds when the power supply has already been cut, or a dual voltage C power strip, capable of changing the voltage at which the electric strike operates by means of a voltage selector, for example, from 12V AC/DC to 24V AC/DC.

In one embodiment of the invention, the plastic base of the power strip comprises holes for the external assembly of a microswitch power strip that indicates the open/closed status of the door in which the electric strike is mounted.

Said microswitch power strip comprises: a PCBA circuit carrying a microswitch together with connection terminals, and a plastic base having clips for the coupling and retention of the PCBA circuit. Said microswitch can be actuated by a pivoting metal plate mounted in the electric strike, which rotates when the door slip enters the electric strike, actuating the microswitch.

The plastic base of the microswitch power strip has flexible, clamp-like attachments that can be coupled by pressure in the assembly holes defined in the base of the power strip for the coupling thereof.

This microswitch power strip is an element outside the electric strike and it can be coupled to the basic power strip and to the 100% ED AC/DC electronic power strip mentioned above at any time during the assembly process of the electric strike, as it does not interfere with the PCBA circuit of the power strip or with any other component of the electric strike.

One feature of the invention is that the power strip, regardless of the components included in the PCBA circuit, incorporates screw terminals.

Once the PCBA circuit has been assembled on the plastic base, the screws that enable the power cables to be connected to the electric strike can be inserted. This operation can be carried out at any time during the assembly process of the electric strike, either when the power strip still has not been connected to the solenoid or when the electric strike is fully assembled.

According to the invention, the solenoid has technical features aimed at forming a solenoid assembly with all the integral components.

The solenoid reel incorporates two pins for contact with the start/end of the coil. These pins are connected to the power strip connector, ensuring proper electrical connection and avoiding the problems currently posed by the connection of the coil wires to the terminals of the connection strip by means of direct soldering.

This invention envisages other alternative connections of the solenoid to the power strip, specifically:
- that the positions of the connection pins and the connector are reversed, i.e., the connection pins are in the PCBA circuit and the connector is in the solenoid or,
- that the solenoid pins are joined to the PCBA circuit by soldering.

In any case, the resulting assembly of parts is rigid and fully integrated, thus eliminating the risks of wire breakage that exist when the coil-power strip joint is flexible and, at the same time, the automation of the assembly process in the electric strike is facilitated.

The assembly is housed in the electric strike box, either with the basic power strip, with the 100% ED AC/DC electronic power strip, with the timed electronic power strip or with the dual voltage power strip.

### Brief description of the contents of the drawings.

As a complement to the description provided herein, and for the purpose of helping to make the features of the invention more readily understandable, the present specification is accompanied by a set of drawings which, by way of illustration and not limitation, represent the following:
- Figure 1 shows a schematic perspective view of an electric strike provided with an electrically actuated device of the invention.
- Figure 2 shows a top plan view of the electrically actuated device mounted inside the electric strike box.
- Figure 3 schematically shows a perspective view of an exemplary embodiment of the electrically actuated device for electric strikes, according to the invention, removed from the electric strike box.
- Figure 4 shows a perspective view of an exemplary embodiment of a basic power strip wherein the PCBA circuit mounted on the base can be seen.
- Figure 5 shows an exploded perspective view of the basic power strip of the previous figure, with the PCBA circuit removed from the base.
- Figure 6 corresponds to a top plan view of the basic power strip in the assembly position of Figure 4.
- Figure 7 shows a partially cross-sectional perspective view of the basic power strip in the mounted position.
- Figures 8 and 9 show rear and front perspective views, respectively, of a variant embodiment of the power strip, suitable in this case to power the solenoid in a range of 100 % ED AC/DC.
- Figure 10 shows an exploded rear elevation view of the power strip of Figures 8 and 9, with the PCBA circuit removed from the base.
- Figures 11 and 12 show rear and front perspective views, respectively, of a variant embodiment of a timed power strip that powers the solenoid for a few seconds in the event of power outage.
- Figure 13 shows an exploded perspective view of the timed power strip of Figures 11 and 12.
- Figures 14 and 15 show rear and front perspective views, respectively, of a dual voltage power strip for powering the solenoid, for example 12 or 24V AC/DC.
- Figure 16 shows an exploded perspective view of the power strip of Figures 14 and 15, with the PCBA circuit removed from the base.
- Figure 17 shows a perspective view of a microswitch that can be coupled to the power strip of the electric strike.
- Figure 18 shows a front perspective view of the microswitch of Fig. 17 coupled to a power strip, in this specific case to the basic power strip of Figure 4.
- Figures 19 and 20 show rear and front perspective views, respectively, of the microswitch power strip with the PCBA circuit removed from the base.
- Figure 21 shows a perspective view of the microswitch power strip mounted on the power strip of an electric strike provided with an actuating plate for said microswitch power strip.
- Figure 22 shows a perspective view of the solenoid with the connection pins facing an electrical power strip having a connector for the coupling thereof.
- Figure 23 shows a variant embodiment of the coupling means for coupling the solenoid to the power strip, wherein the solenoid pins are joined by soldering to the PCBA circuit of the power strip.
- Figure 24 shows a second variant embodiment of the connection means for connecting the solenoid to the power strip, in this case the pins being fixed to the power strip and the connector fixed to the solenoid.

### Detailed description of embodiments of the invention.

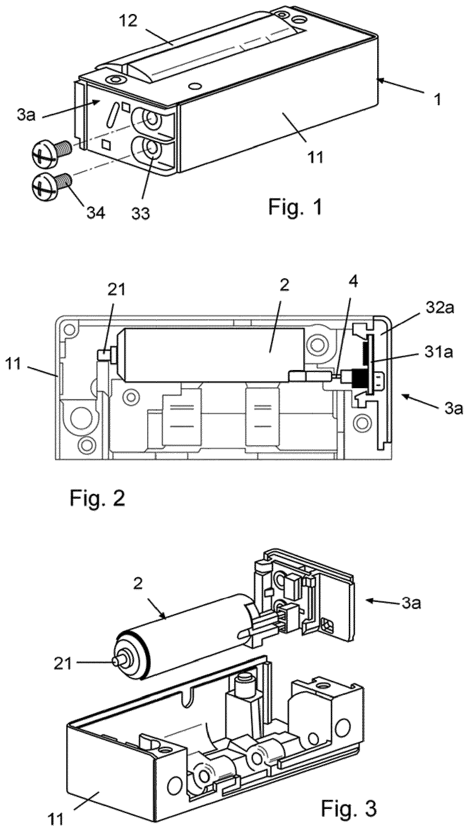

Figures 1 to 3 schematically show an electric strike (1) having a housing (11) in which a pivoting latch (12) is mounted between: a locked position, suitable for retaining the slip of a lock of a door or enclosure in a closed position, and an unlocked position in which said latch (12) can move freely towards a position for releasing the slip of the lock and opening the door in question.

The locking of the latch (12) in this type of electric strike is generally performed by means of a mechanism, not shown, which is unlocked by means of an electrically actuated device comprising a solenoid (2) connected to an electrical power strip and which when powered electrically moves a core (21) of the solenoid (2) that acts on the electric strike mechanism causing its release.

In the aforementioned Figures 1 to 4, like in the different exemplary embodiments that will be explained below, the power strip, represented in this case by a basic power strip (3a), comprises a PCBA circuit (31a) which can be coupled to a base (32a) that can be coupled to the housing (11) of the electric strike without using screws or soldering.

Additionally, the electrical connection between the basic power strip (3a) and the solenoid (2) is established by means of rigid pins (4) that fit into connectors (5) such that both elements (2, 3a) form a solid assembly.

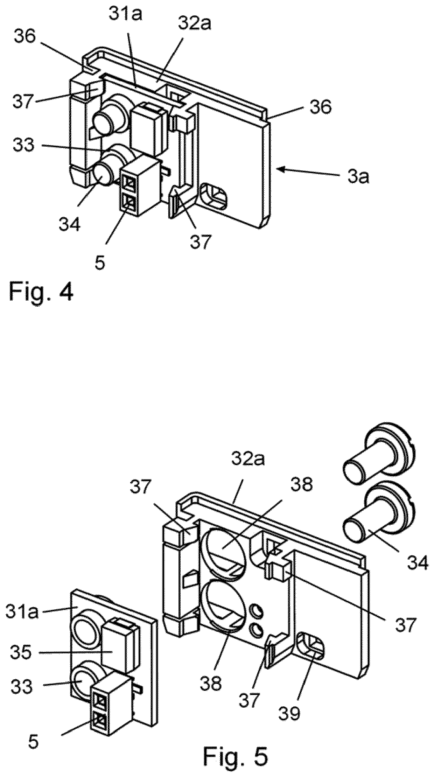

As can be seen in greater detail in Figures 4 and 5, the PCBA circuit (31a) of the basic power strip (3a) comprises: screw terminals (33) for the mounting of power screws (34) visible in Figure 2, a possible element (35) for protecting against voltage surges and the connector (5) for the connection pins (4) that in this case are fixed to the solenoid (2).

The base (32a) of the basic power strip (3a) comprises: lateral guides (36) for the mounting thereof in the housing (11) of the electric strike; clips (37) on the inner surface thereof for the pressure coupling and retention of the PCBA circuit (31), and through holes (38) for the fitted housing of the screw terminals (33) of the PCBA circuit.

To mount the PCBA circuit (31a) on the base (32a), it is enough to position the PCBA circuit parallel to the base as shown in Figure 5 and then move it perpendicular to said base (32a) so that the clips (37) are elastically deformed outwards, allowing the passage of the PCBA circuit (31a) towards the housing delimited by the same, reaching the position represented in Figures 4, 6 and 7.

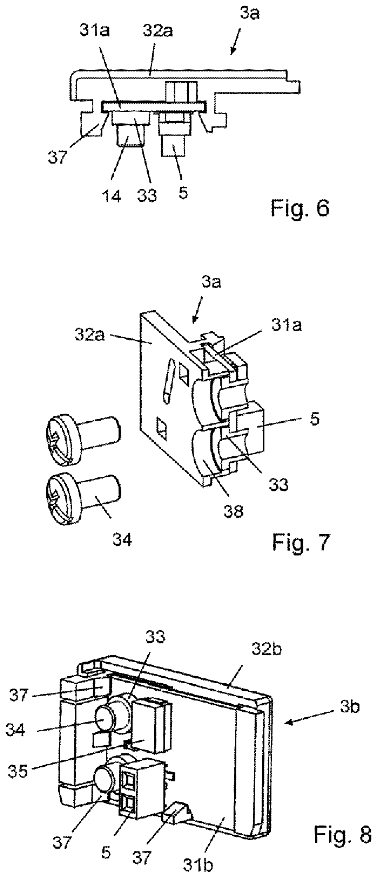

In this coupling position, the PCBA circuit (31a) has movement completely restricted both by the action of the clips (37) and by the screw terminals (33) that are housed in the holes (38) and surrounded by the plastic of the base (32a) as seen in Figure 7.

In this embodiment, the fastening clips (37) are arranged in facing positions for attaching to two opposite sides of the PCBA circuit (31a) of the basic power strip (3a).

As mentioned above, the invention contemplates the embodiment of connection strips of different sizes and features, the base maintaining in any case the aforementioned features related to the incorporation of screw terminals (33) for the mounting of power screws (34), and clips (37) for the coupling or assembly of the corresponding PCBA circuit, regardless of the type of power supply or the functions provided by said PCBA circuit.

In this sense, Figures 8 to 10 show different assembled and exploded views of an electronic power strip (3b) comprising a PCBA circuit (31b) suitable to allow the solenoid to be powered in a range of 100% ED AC/DC and a base (32b) with the corresponding fastening clips (37) of the PCBA circuit and holes (38) for the fitted housing of the power screw terminals (34).

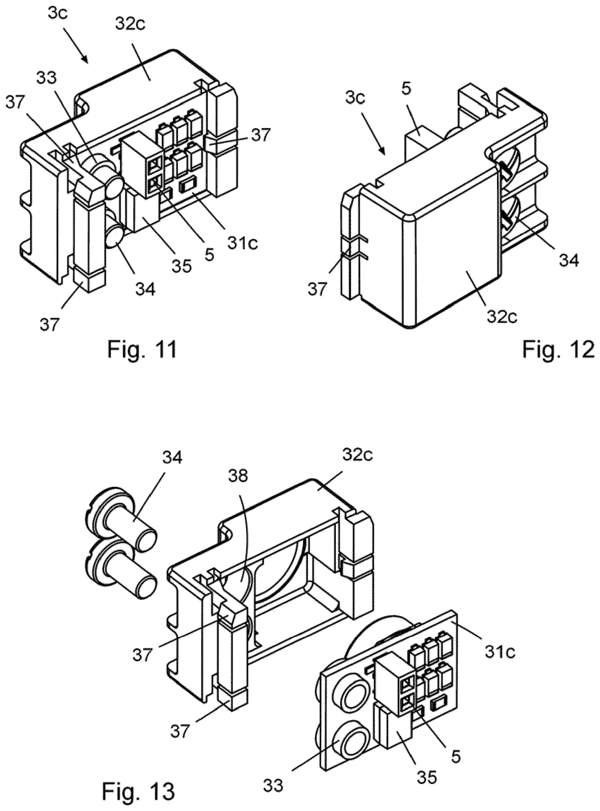

Figures 11 to 13 show a variant embodiment of the power strip represented in this case by a timed electronic power strip (3c) comprising a PCBA circuit (31c) suitable for providing the solenoid (2) with power for a few seconds when the external power supply has already been cut and a base (32c) with the corresponding fastening clips (37) of the PCBA circuit (31c) and holes (38) for the fitted housing of the power screw terminals (34).

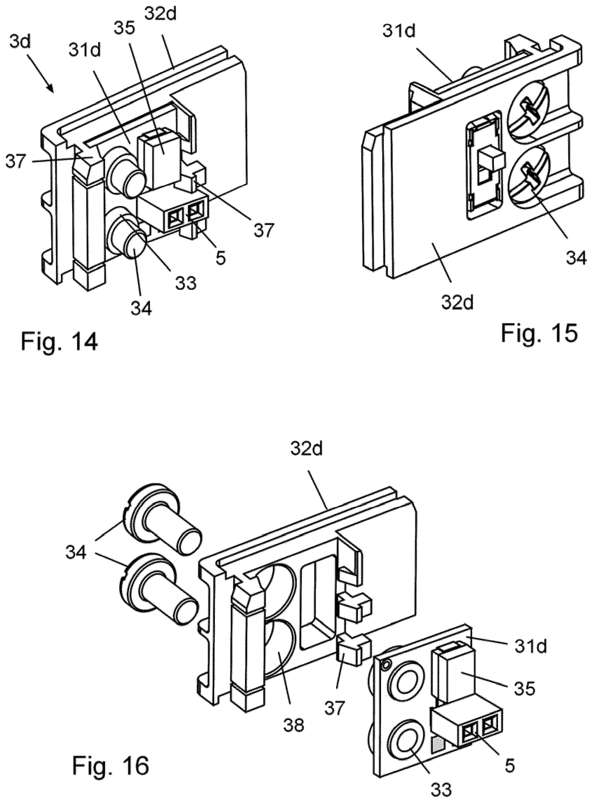

Figures 14 to 16 show a dual voltage power strip (3d) for powering the solenoid, for example from 12 AC/DC to 24V AC/DC, having a PCBA circuit (31d) that is also fixed to the base (32d) by means of fastening clips (37). Said PCBA circuit (31d) comprises, in addition to the screw terminals (33) and the possible element for protecting against voltage surges (35), a suitable switch to select between two supply voltages of the solenoid (2). In this specific embodiment, since a dual-coil solenoid (2) is necessary, the connection between the solenoid (2) and the dual voltage power strip (3d) is created by soldering, providing the PCBA circuit with 2 pads to carry out said solders and two connectors (5) to connect two pins (4) to the solenoid, also ensuring the solid joint of the power strip and the solenoid.

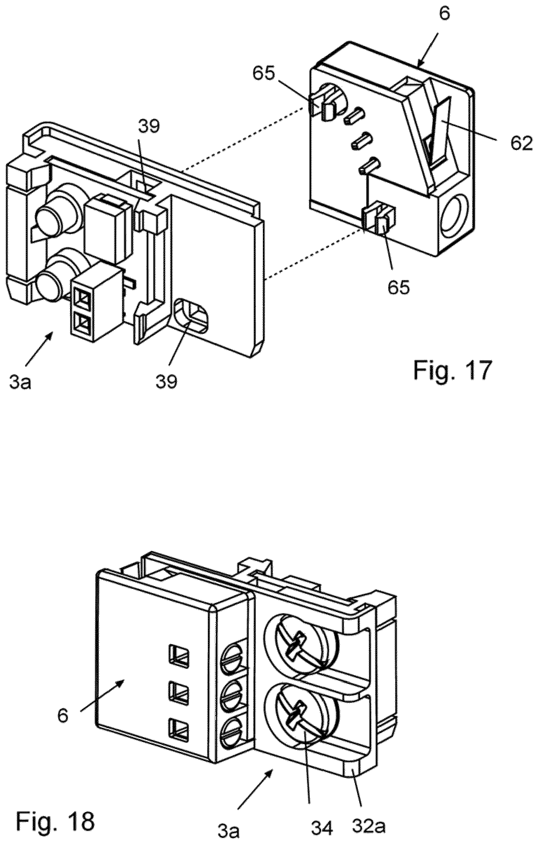

It has been envisaged that the electrical power supply device of the invention may include in some embodiments a microswitch power strip (6) that indicates the open/closed status of the door in which the electric strike shown in Figures 17 to 21 is mounted.

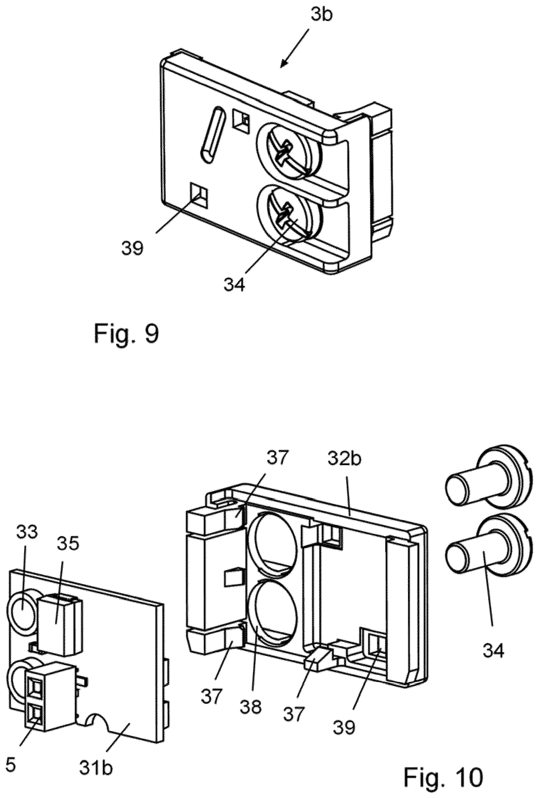

Said microswitch power strip (6) comprises a PCBA circuit (61), carrying a microswitch (62) together with connection terminals (63), and which is assembled on a plastic base (64) having flexible clamp-like attachments (65) that can be coupled by pressure into assembly holes (39) defined for this purpose in the base (32a) of the basic power strip (3a) shown in Figures 4, 5, 17 and 18, and in the base (32b) of the electronic power strip (3b) shown in Figures 9 and 10.

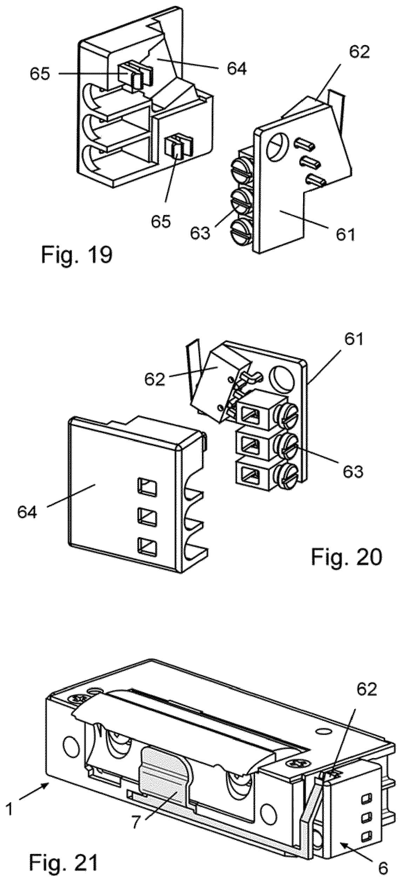

As shown in figure 21, the microswitch (62) can be actuated by a pivoting metal plate (7) mounted in the electric strike (1), which rotates when the door slip enters the electric strike, actuating the microswitch (62).

This microswitch power strip (6) is an element outside the electric strike (1) and it can be coupled to several electrical power strips, such as the basic power strip (3a) and the electronic power strip (3b) with 100% ED AC/DC power at any time during the assembly process of the electric strike (1), as it does not interfere with the PCBA circuit (31a, 31b) of said power strips (3a, 3b) or with any other component of the electric strike (1).

Before or after assembling the PCBA circuit (61) to the plastic base (64), the screws (34) that enable the power cables to be connected to the electric strike (1) can be inserted. This operation can be carried out at any time during the assembly process of the electric strike (1), either when the power strip (3a-3d) still has not been connected to the solenoid (2) or when the electric strike (1) is fully assembled.

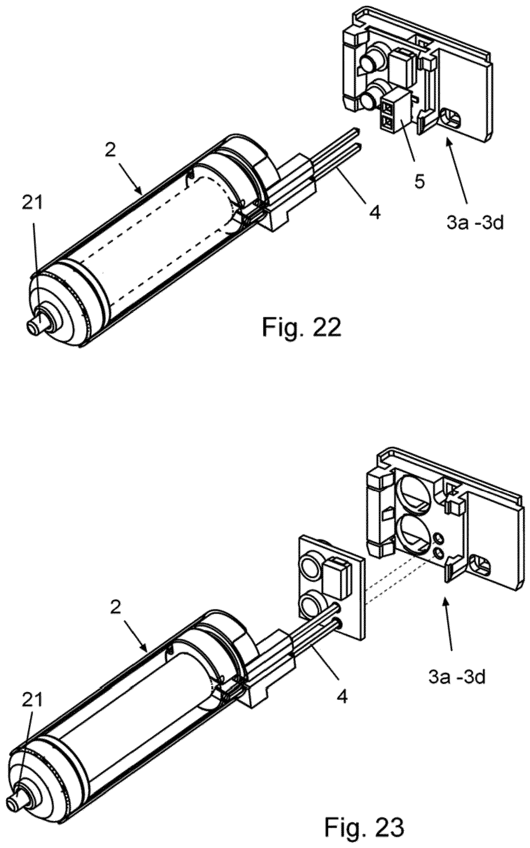

In the embodiment shown in Figure 22, the solenoid (2), carrier of the movable core (21), comprises two pins (4) for the connection thereof to the connector (5) of the power strip (3a-3d) mounted in each case in the electrical power supply device of the electric strike (1).

Figure 23 shows a variant embodiment of the coupling means for coupling the solenoid (2) to any one of the power strips (3a-3d), wherein the solenoid pins (4) are fixed to the PCBA circuit of the power strip by soldering.

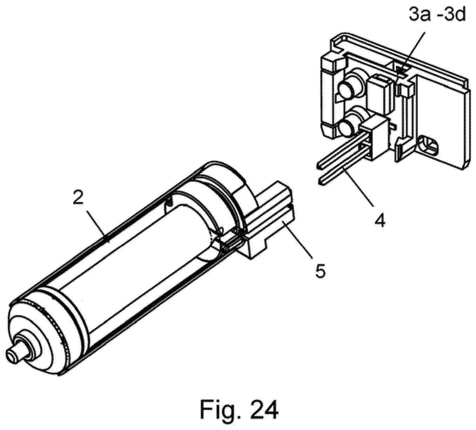

Figure 24 shows a second variant embodiment of the connection means, wherein the pins (4) are fixed to the power strip (3a-3d) and the connector (5) is fixed to the solenoid (2).

Having sufficiently described the nature of the invention, in addition to a preferred exemplary embodiment, it is hereby stated for the relevant purposes that the materials, shape, size and layout of the described elements may be modified, provided that it does not imply altering the essential features of the invention claimed below.

## Claims

1. An electrically actuated device for electric strikes, comprising a pivoting latch (12) and a solenoid (2) connected to an electrical power strip and which when powered electrically moves a core (21) of the solenoid (2) that acts on the locking and unlocking mechanism of the pivoting latch (12); wherein the electrical power strip (3a - 3d) comprises:
- a PCBA circuit (31a-31d) comprising: screw terminals (33) for mounting power screws (34) and, possibly, an element for protecting against voltage surges (35); **characterised in that** the electrical power strip (3a-3d) further comprises:
- a plastic base (32a - 32d) that can be coupled to the outside of an electric strike (1) and that has clips (37) on the inside surface thereof for the pressure coupling and retention of the PCBA circuit, and through holes (38) for the fitted housing of the screw terminals (33) of the PCBA circuit, such that in the coupling position with the base the PCBA circuit has completely restricted movement and,
- rigid pins or connectors (4) that establish an electrical connection between the PCBA circuit and a solenoid coil and mechanically secure the solenoid and the power strip in a solid and/or resistant assembly.

2. The device according to claim 1, **characterised in that** the power strip consists of: a basic power strip (3a), or an electronic power strip (3b) for powering the solenoid in a range of 100% ED AC/DC, or a timed electronic power strip (3c), or a dual voltage power strip (3d) to power the solenoid preferably from 12V to 24V AC/DC.

3. The device according to any one of the preceding claims; **characterised in that** it comprises, externally to the electric strike, a microswitch power strip (6) that indicates the open/closed status of a door, and a pivoting metal plate (7) for actuating said microswitch power strip mounted on the electric strike (1).

4. The device according to claim 3, **characterised in that** the microswitch power strip (6) comprises a PCBA circuit (61) carrying a microswitch (62) together with connection terminals (63), and assembled on a plastic base (64) having flexible clamp-like attachments (65) that can be coupled by pressure into assembly holes (39) defined in the basic power strip (3a) and in the 100% ED AC/DC electronic power strip (3b).

5. The device according to any one of claims 1 to 4, **characterised in that** the connection pins (4) are fixed to the solenoid (2).

6. The device according to claim 5, **characterised in that** the PCBA circuit (31a, 31b, 31c) of the power strip (3a, 3b, 3c) comprises connectors (5) for coupling the solenoid pins (4).

7. The device according to claim 5, **characterised in that** the connection pins (4) are fixed to the PCBA circuit of the power strip by soldering.

8. The device according to any one of claims 1 to 4, **characterised in that** the connection pins (4) are fixed in the PCBA circuit (31a-31d) of the power strip (3a-3d) and the solenoid (2) comprises connectors (5) for connecting the pins (4).

## Patentansprüche

1. Elektrisch betätigte Vorrichtung für elektrische Türöffner, umfassend einen schwenkbaren Riegel (12) und einen Elektromagneten (2), der mit einer elektrischen Steckdosenleiste verbunden ist und bei elektrischer Stromversorgung einen Kern (21) des Elektromagneten (2) bewegt, der auf den Verriegelungs- und Entriegelungsmechanismus des schwenkbaren Riegels (12) einwirkt; wobei die elektrische Steckdosenleiste (3a - 3d) Folgendes umfasst:
- eine PCBA-Schaltung (31a-31d) umfassend: Schraubklemmen (33) zur Montage von Leistungsschrauben (34) und, möglicherweise, ein Element zum Schutz vor Spannungsspitzen (35); **dadurch gekennzeichnet, dass** die elektrische Steckdosenleiste (3a-3d) ferner Folgendes umfasst:
- eine Kunststoffbasis (32a - 32d), die an der Außenseite eines elektrischen Türöffners (1) befestigt werden kann und an ihrer Innenfläche Clips (37) für die Druckkopplung und Halterung der PCBA-Schaltung sowie Durchgangslöcher (38) für das Einbaugehäuse der Schraubklemmen (33) der PCBA-Schaltung aufweist, so dass in der Kopplungsposition mit der Basis die Bewegung der PCBA-Schaltung vollständig eingeschränkt ist und
- starre Stifte oder Anschlüsse (4), die eine elektrische Verbindung zwischen der PCBA-Schaltung und einer Elektromagnetspule herstellen und den Elektromagneten und die Steckdosenleiste mechanisch in einer festen und/oder widerstandsfähigen Baugruppe sichern.

2. Vorrichtung nach Anspruch 1, **dadurch gekennzeichnet, dass** die Steckdosenleiste aus Folgendem besteht: einer Basis-Steckdosenleiste (3a) oder einer elektronischen Steckdosenleiste (3b) zur Stromversorgung des Elektromagnets in einem Bereich von 100 % ED AC/DC, oder einer zeitgesteuerten elektronischen Steckdosenleiste (3c), oder einer Doppelspannungs-Steckdosenleiste (3d), um den Elektromagneten vorzugsweise mit 12 V bis 24 V AC/DC zu versorgen.

3. Vorrichtung nach einem der vorhergehenden Ansprüche, **dadurch gekennzeichnet, dass** sie Folgendes umfasst: außerhalb des elektrischen Türöffners, eine Mikroschalter-Steckdosenleiste (6), die den Offen-/Geschlossen-Status einer Tür anzeigt, und eine schwenkbare Metallplatte (7) zur Betätigung der Mikroschalter-Steckdosenleiste, die am elektrischen Türöffner (1) montiert ist.

4. Vorrichtung nach Anspruch 3, **dadurch gekennzeichnet, dass** die Mikroschalter-Steckdosenleiste (6) eine PCBA-Schaltung (61) umfasst, die einen Mikroschalter (62) zusammen mit Anschlussklemmen (63) trägt und auf einer Kunststoffbasis (64) montiert ist, die flexible, klemmenartige Befestigungen (65) aufweist, die durch Druck in Montagelöcher (39) eingekuppelt werden können, die in der Basis-Steckdosenleiste (3a) und in der elektronischen 100 % ED AC/DC-Steckdosenleiste (3b) definiert sind.

5. Vorrichtung nach einem der Ansprüche 1 bis 4, **dadurch gekennzeichnet, dass** die Anschlussstifte (4) am Elektromagneten (2) befestigt sind.

6. Vorrichtung nach Anspruch 5, **dadurch gekennzeichnet, dass** die PCBA-Schaltung (31a, 31b, 31c) der Steckdosenleiste (3a, 3b, 3c) Anschlüsse (5) zur Kopplung der Elektromagnetstifte (4) umfasst.

7. Vorrichtung nach Anspruch 5, **dadurch gekennzeichnet, dass** die Anschlussstifte (4) durch Löten an der PCBA-Schaltung der Steckdosenleiste befestigt werden.

8. Vorrichtung nach einem der Ansprüche 1 bis 4, **dadurch gekennzeichnet, dass** die Anschlussstifte (4) in der PCBA-Schaltung (31a-31d) der Steckdosenleiste (3a-3d) befestigt sind und der Elektromagnet (2) Anschlüsse (5) zum Anschließen der Stifte (4) umfasst.

## Revendications

1. Dispositif actionné électriquement pour gâches électriques, comprenant un loquet pivotant (12) et un solénoïde (2) connecté à une barrette d'alimentation électrique et qui, lorsqu'il est alimenté électriquement, déplace un noyau (21) du solénoïde (2) qui agit sur le mécanisme de verrouillage et de déverrouillage du loquet pivotant (12) ; dans lequel la barrette d'alimentation électrique (3a - 3d) comprend :
- un circuit PCBA (31a-31d) comprenant : des bornes à vis (33) pour le montage de vis d'alimentation (34) et, éventuellement, un élément de protection contre les surtensions (35) ; **caractérisé en ce que** la barrette d'alimentation électrique (3a-3d) comprend en outre :
- une base en plastique (32a - 32d) qui peut être couplée à l'extérieur d'une gâche électrique (1) et qui a des clips (37) sur sa surface intérieure pour le couplage par pression et la retenue du circuit PCBA, et des trous traversants ( 38) pour le logement encastré des bornes à vis (33) du circuit PCBA, de telle sorte que dans la position de couplage avec la base, le circuit PCBA a un mouvement complètement limité et,
- des broches ou connecteurs rigides (4) qui établissent une connexion électrique entre le circuit PCBA et une bobine de solénoïde et fixent mécaniquement le solénoïde et la barrette d'alimentation dans un ensemble solide et/ou résistant.

2. Dispositif selon la revendication 1, **caractérisé en ce que** la barrette d'alimentation consiste en : une barrette d'alimentation de base (3a), ou une barrette d'alimentation électronique (3b) pour alimenter le solénoïde dans une plage de 100 % ED CA/CC, ou une barrette d'alimentation électronique temporisée (3c), ou une d'alimentation bi-tension (3d) pour alimenter le solénoïde de préférence de 12V à 24V CA/CC.

3. Dispositif selon l'une quelconque des revendications précédentes ; **caractérisé en ce qu'**il comprend, à l'extérieur de la gâche électrique, une barrette d'alimentation à micro-interrupteur (6) qui indique l'état ouvert/fermé d'une porte, et une plaque métallique pivotante (7) pour actionner ladite barrette d'alimentation à micro-interrupteur montée sur la gâche électrique (1).

4. Dispositif selon la revendication 3, **caractérisé en ce que** la barrette d'alimentation à micro-interrupteur (6) comprend un circuit PCBA (61) portant un micro-interrupteur (62) conjointement avec des bornes de connexion (63), et assemblé sur une base en plastique (64) ayant des attaches flexibles en forme de pince (65) qui peuvent être couplées par pression dans des trous d'assemblage (39) définis dans la barrette d'alimentation de base (3a) et dans la barrette d'alimentation électronique 100 % ED CA/CC (3b).

5. Dispositif selon l'une quelconque des revendications 1 à 4, **caractérisé en ce que** les broches de connexion (4) sont fixées au solénoïde (2).

6. Dispositif selon la revendication 5, **caractérisé en ce que** le circuit PCBA(31a, 31b, 31c) de la barrette d'alimentation (3a, 3b, 3c) comprend des connecteurs (5) pour coupler les broches du solénoïde (4).

7. Dispositif selon la revendication 5, **caractérisé en ce que** les broches de connexion (4) sont fixées au circuit PCBA de la barrette d'alimentation par soudure.

8. Dispositif selon l'une quelconque des revendications 1 à 4, **caractérisé en ce que** les broches de connexion (4) sont fixées dans le circuit PCBA (31a-31d) de la barrette d'alimentation (3a-3d) et le solénoïde (2) comprend des connecteurs (5) pour connecter les broches (4).
